# EUROPEAN PATENT APPLICATION

(11) **EP 0 908 308 A1**
(43) Date of publication of application: **14.04.1999**
(21) Application number: 98203275.7
(22) Date of filing: 29.09.1998
(51) Int. Cl.: B41C 1/10, B41M 5/36

(54) **Positive working radiation sensitive compositions containing a large proportion of carbon black which are laser imageable**

(30) Priority: 06.10.1997 US 944218
(71) Applicant: Bayer Corporation, Pittsburgh, PA 15219-2502 (US)
(72) Inventor: Koletar, Gabor I., Berkeley Heights, New Jersey 07922 (US); Seeley, Douglas A., High Bridge, New Jersey 088029 (US)
(74) Representative: Ramon, Charles Lucien

(57) **Abstract**

Radiation sensitive lithographic compositions suitable for laser induced imaging, which contain a positive working radiation sensitive compound, an aqueous alkali soluble resin and a relatively large proportion of carbon black. Such compositions, when coated on a metal substrate and imagewise exposed to laser induced infrared radiation form a positive image after development with an aqueous alkaline solution. Exposing is conducted with laser light at a wavelength in the range of from about 800 to about 1100 nm at an energy level of from about 50 to about 250 mJ/cm².

## Description

### BACKGROUND OF THE INVENTION

### FIELD OF THE INVENTION

The present invention relates to radiation sensitive compositions and particularly to lithographic compositions suitable for laser induced imaging, which contain a positive working radiation sensitive compound, an aqueous alkali soluble resin and a relatively large proportion of carbon black. Such compositions, when coated on a metal substrate and imagewise exposed to laser induced infrared radiation form a positive image after development with an aqueous alkaline solution.

### DESCRIPTION OF THE PRIOR ART

The art of lithographic printing is based upon the immiscibility of grease and water, and takes advantage of this phenomenon by utilizing the preferential retention of a transferable, greasy ink on an image area of a lithographic printing plate and the similar retention on a corresponding non-image area of an aqueous dampening fluid. If an oleophilic image is formed upon a suitable surface and the entire surface then is moistened with an aqueous solution, the image area will repel water whereas the non-image area will retain water. Upon subsequent application to the entire surface of a greasy ink, the image portion of the surface retains the ink whereas' the moistened non-image portion repels it. The ink on the image area then can be transferred to the surface of a suitable material on which the image is to be reproduced, such as paper or the like. Lithographic plates, such as those to which the present invention pertain have a coating of a light sensitive composition that is adherent to a suitable base sheet material, for example, an aluminum sheet.

Radiation sensitive compositions useful for lithography are generally categorized as being either positive working or negative working. In a negative working composition, the imagewise light struck areas harden and form the image areas after removal of the unexposed areas with a developer. In a positive working composition the exposed areas are the removed non-image areas when the light struck parts are rendered soluble in aqueous alkali developers. A positive plate differs from a negative plate in that the hydrophilic non-image area is formed in the portion of the light-sensitive coating exposed to light through a positive image transparency and the unexposed portion is either oleophilic or convertible to an oleophilic state to form the ink-receptive image area.

It is well known in the art to produce positive working formulations such as those described in United States Patent Nos. 3,666,473, 4,115,128 and 4,173,470. These include alkali soluble phenol-formaldehyde novolak resins together with light sensitive materials, usually a substituted naphthoquinone diazide compound. The resins and sensitizers are dissolved in an organic solvent or mixture of solvents and are applied as a thin film or coating to a substrate suitable for the particular application desired. The resin component of these photoresist formulations is soluble in aqueous alkaline solutions, but the naphthoquinone sensitizer is not. Upon imagewise exposure of the coated substrate to ultraviolet radiation, the sensitizer is rendered more soluble than the unexposed areas. This difference in solubility rates causes the exposed areas of the coating to be dissolved when the substrate is immersed in an alkaline developing solution, while the unexposed areas are largely unaffected, thus producing a positive relief pattern on the substrate.

One problem with prior art lithographic coatings is that they are generally required to be imagewise exposed to ultraviolet radiation through an exposure mask. This requires the time consuming preparation of such a mask. In addition, once made, the images on these exposure masks are fixed and cannot be changed. If a modification is required, an entirely new mask must be made. It is known in the art that images are more productively created by digital computer representations and it would be desirable to cause a lithographic printing plate to be directly exposed via exposure equipment without the intermediary step of preparing an exposure mask. Computer created digital images are easily changed without the need for mask recreation. Such computer to plate techniques are also well known in the art. A computer image is imparted to laser scanning equipment and a plate is exposed via laser exposure to a raster scanned image representation. A problem with prior art laser exposure techniques is that images are formed on printing pate surfaces by ablative absorption of imaging infrared radiation. An infrared absorbing coating is first applied to a substrate and then exposure to an infrared laser pulse ablates the coating surface and weakens it so that it is no longer anchored to the underlying substrate. A problem with these ablative systems is that high power sources of at least 0.2 megawatts/in² are required for imaging. In this regard see U.S. patents 5,385,092 and 5,379,698. The present invention provides an improved radiation coating which is infrared absorbing.

It is known in the art that o-quinone diazides are uv sensitive but not infrared sensitive. The present invention renders the o-quinone diazide infrared sensitive and forms A coating containing a high proportion of carbon black which is infrared absorbing. It has been unexpectedly found that the infrared energy absorbed by the carbon black is transferred to a normally uv sensitive, positive working o-quinone diazide composition which becomes alkali soluble upon such energy transfer and hence soluble in aqueous alkali developers. Exposure may hence be conducted at much lower energy levels than are required for ablation imaging.

### SUMMARY OF THE INVENTION

The invention provides a positive working radiation sensitive composition suitable for laser induced imaging which comprises in admixture a water insoluble binder resin component which is either aqueous alkali soluble or swellable or becomes aqueous alkali soluble or swellable upon exposure, in an amount sufficient to form a uniform film of the composition components when it is coated on a substrate and dried; an o-quinone diazide radiation sensitive component in an amount sufficient to radiation sensitize the composition; and carbon black in an amount sufficient to absorb sufficient infrared radiation to cause the diazide to solubilize.

The invention also provides a positive working radiation sensitive element suitable for laser induced imaging which comprises a metal substrate and the above positive working radiation sensitive composition coated and dried on the substrate.

The invention further provides a method for forming a positive image which comprises imagewise exposing the above positive working radiation sensitive element with laser light at a wavelength in the range of from about 800 to about 1100 nm at an energy level of from about 50 to about 250 mJ/cm² and subsequently developing by removing the exposed nonimage areas with an aqueous alkaline developer solution.

### DETAILED DESCRIPTION OF THE PREFERRED EMBODIMENT

As a first step in the production of the photographic element of the present invention, one coats and dries the foregoing infrared radiation sensitive composition on a suitable substrate. In the preferred embodiment the composition contains a water insoluble, aqueous alkaline soluble or swellable binding resin, a quinone diazide sensitizer and carbon black.

The preferred binding resins include the classes known as the novolaks. The production of novolak resins is well known in the art. A procedure for their manufacture is described in Chemistry and Application of Phenolic Resins, Knop A. and Scheib, W.; Springer Verlag, New York, 1979 in Chapter 4 which is incorporated herein by reference. Suitable novolak resins employed by this invention are water insoluble, aqueous alkali soluble resin obtained by condensing with formaldehyde a mixture of from about 2.0 to about 5.0 mol percent of 2,4-xylenol, from about 1.5 to about 4.5 mol percent of 2,5-xylenol, from about 1.5 to about 4.0 mol percent of 2,6-xylenol, from about 2.0 to about 5.0 mol percent o-ethylphenol, and the balance m-cresol and p-cresol in a respective mol ratio of from about 0.5 to about 2.0 to 1. The novolak resin has a preferred molecular weight in the range of from about 6,000 to about 14,000, or more preferably from about 8,000 to about 12,000. Preferred novolak resins include Alnovol 420, commercially available from Hoechst AG.

The condensation may be conducted by forming an admixture of the 2,4-xylenol; 2,5-xylenol; 2,6-xylenol, o-ethylphenol, m-cresol, and p-cresol and a catalytic amount of oxalic acid, and heating the mixture at from about 90°C to about 110 °C with agitation. To the heated mixture is added an aqueous solution of formaldehyde, such as for example a 35 % to about 41 % aqueous solution. The preferred amount of oxalic acid may range from about 0.5 % to about 2.0 % based on total cresols. This latter solution may be added to the former dropwise over the course of about 2 hours to about 4 hours. The mixture is allowed to react to completion for about 5 hours to about 8 hours at about 90 °C to about 100°C.

The water insoluble, aqueous alkaline soluble or swellable binding resin component is preferably present in the overall composition in an amount of from about 70 % to about 94 %, more preferably from about 75 % to about 90 % and most preferably from about 80 % to about 85 %.

The composition then contains a positive working o-quinone diazide radiation sensitizer. These sensitizers which comprise a component of the compositions of the present invention are preferably selected from the group of substituted naphthoquinone diazide sensitizers which are conventionally used in the art in positive photolithographic formulations. Suitable compounds include the o-quinone-4-or-5-sulfonyl-diazides. Such sensitizing compounds are disclosed in United States Letters Patent Nos. 2,797,213; 3,106,465; 3,148,983; 3,130,047; 3,201,329; 3,785,825; and 3,802,885, which are incorporated herein by reference. The o-quinone diazides are well known to the skilled artisan as demonstrated by Light Sensitive Systems, Kosar, J.; John Wiley & Sons, New York, 1965 in Chapter 7.4 which is also incorporated herein by reference. It presently appears that the number of fused rings is not important for this invention but the position of the sulfonyl group is important. That is, one may use benzoquinones, naphthoquinones or anthroquinones, preferably the oxygen is in the 1 position, diazo is in the 2 position and the sulfonyl group is in the 4 position. Likewise the phenolic member to which it is attached does not appear to be important. For example it can be a cumylphenol derivative as taught in U.S. 3,640,992 or it can be a mono-, di-, or tri-hydroxyphenyl alkyl ketone or benzophenone as shown in U.S. 4,499,171 which are incorporated herein by reference. Useful radiation sensitizers for the present invention also include an ester of 2,3,4,4'-tetrahydroxybenzophenone, having on the average, from about 60 mol percent to about 100 mol percent of the hydroxy groups of the 2,3,4,4'-tetrahydroxybenzophenone having been esterified by 1,2-naphthoquinonediazide-5-sulfonic acid. This compound is not new in and of itself. Its production is described in U.S. Patents 3,106,465, and 4,719,167 which are incorporated herein by reference. Preferred radiation sensitive components are 1,2-naphthoquinone diazide-4 or 5-sulfonic acid esters such as a trihydroxybenzophenone-1,2-naphthoquinone diazide-4 or 5-sulfonic acid trisester. The diazide component is preferably present in an amount of from about 5% to about 30 % by weight of the composition, more preferably from about 8 % to about 25 % and most preferably from about 10 % to about 15 %.

The composition further contains carbon black in an amount sufficient to absorb sufficient infrared radiation to cause the diazide to solubilize. The carbon black component is preferably present in an amount of from about 5 to about 10 % by weight of the composition. A more preferred range is from about 8 % to about 10 % by weight of the composition. In the usual case, the pure carbon black is not directly blended into the composition, but is first formed into a dispersion of a binding resin such as the above novolak or another compatible binder such as a polvvinyl acetal or other phenolics. Useful binding resins include those disclosed in U.S. patents 4,665,124 and 4,631,245 which are incorporated herein by reference.

The radiation sensitive composition is formed by blending the ingredients in a suitable solvent and coating on a metal substrate. Useful solvents include butyl acetate, xylene, ethylene glycol monoethyl ether acetate, and most preferably propylene glycol mono-methyl ether acetate, among others. The coating solvents may be present in the overall composition in an amount of up to 95% by weight of the solids in the composition. Solvents, of course are substantially removed after coating of the solution on a substrate and drying.

Other optional ingredients which may be present include surfactants such as non-ionic surfactants, plasticizers, acid generators, crosslinkers, contrast enhancing agents and absorbers. Non-ionic surfactants that may be used include, for example, nonylphenoxy poly(ethyleneoxy) ethanol; octylphenoxy ethanol at up to 10% by weight of the composition.

Plasticizers which may be used include, for example, phosphoric acid tri-(beta-chloroethyl)-ester; stearic acid; dicamphor; polypropylene; acetal resins; phenoxy resins; and alkyl resins at up to 10% by weight of the composition. The plasticizer additives improve the coating properties of the material and enable the application of a film that is smooth and of uniform thickness to the substrate. Acid generators include pyrilium and oxonium compounds; Crosslinkers include melamine based compounds such as Cymel 303. Absorbers include squarilium, croconic acid and naphthalocyanine dyes.

Contrast enhancing agents may include weak organic acids such as monomeric phenols and polyhydroxy aromatic compounds and substituted benzoic acids.

The radiation sensitive composition is then coated onto a suitable metal substrate and dried. Suitable substrates include aluminum, aluminum alloys, and other metals and metal alloys such as steel, stainless steel, zinc, copper and chromium. The most preferred substrate is a lithographic grade aluminum alloy which may have had art recognized surface treatments performed on it. When such is the case, a sheet metal substrate, preferably aluminum and the alloys thereof especially those aluminum compositions suitable for the manufacture of lithographic printing plates such as Alcoa 3003 and Alcoa 1100, which may or may not have been pre-treated by standard techniques as are well known in the art, may be treated by spraying, brushing, dipping or other means with a composition suitable for use as a hydrophilizing interlayer for lithographic plates. Standard metal substrate pretreatments include chemical etching, chemical, electrochemical or mechanical graining and anodizing by methods which are known to the skilled worker. A grain may be imparted to the aluminum surface by wire brushing or a pumice slurry or electrochemically grained in nitric acid followed by desmutting. Mechanical and chemical graining methods are disclosed in U.S. patents 2,882,153 and 2,882,154. Anodizing may be performed by electrolytically treating the coated substrate in an aqueous solution of sulfuric, chromic, or phosphoric acid having a concentration of from about 0.5 to 25% by weight of acid in water. Anodizing preferably takes place in a bath maintained at a temperature of from about 15 °C to 35 °C for about from 1 to about 20 minutes at about from 5 to 20 volts and at a current density of about from 10 to 70 amperes per square foot. The foregoing techniques are well known in the art as exemplified by U.S. patent 3,440,050.

The substrate may be treated with an aqueous solutions of a hydrophilizing compound such as alkali silicate, silicic acid, the Group IV-B metal fluorides, the alkali metal salts, polyvinyl phosphonic acid, polyacrylic acid, the alkali zirconium fluorides, such as potassium zirconium hexafluoride, or hydrofluozirconic acid in concentrations of from about 0.5 % to about 20% by volume. A preferred concentration range is from about 3 % to about 8 % and the most preferred range is from about 4 to about 5%. Such techniques are disclosed in U.S. patents 2,946,683 and 3,160,506.

The coating is preferably applied to a properly prepared lithographic plate substrate by any well known coating technique and the solvents are evaporated to yield a dry coating weight of from about 0.7 to about 2 g/m², more preferably from about 1.0 to about 1.8 g/m², and most preferably from about 1.2 to about 1.5 g/m².

The thusly produced photographic element may then be exposed to infrared radiation, such as in the 800 to 1100 nanometer range through a raster scanned laser in a pattern representing digital data and developed. Suitable laser light sources are diode lasers which discharge at a wavelength of about 830 nm, YLF (Nd-doped Yttrium Lithium Fluoride) solid state lasers which discharge at a wavelength of about 1053 nm, and Nd:YAG lasers which discharge at a wavelength of about 1064 nm. Exposure is conducted to provide sufficient energy to the element surface to permit solubilization of the diazide compound, such as at an energy level of from about 50 to about 250 mJ/cm², or preferably from about 100 to about 150 mJ/cm². The duration of exposure depends on the total exposure energy level selected and generally is on the order of nanoseconds to microseconds.

The nonimage areas are then removed with a suitable developer. Typical developer compositions are alkaline or neutral in nature and have a pH range of from about 10 to about 14, preferably from about 12.5 to about 13.5. Developers are preferably formed from aqueous solutions of phosphates, silicates, metasilicates, hydroxides or metabisulfites. Such non-exclusively include mono-, di- and tri- alkali metal phosphate, alkali metal silicates such as sodium silicate, alkali metal metasilicate and alkali metabisulfite; and alkali metal hydroxides such as sodium hydroxide and potassium hydroxide. The developers may also contain art recognized surfactants, buffers and other ingredients. Suitable developers are commercially available as P800 and PD261 from Agfa Division of Bayer Corporation, Somerville, New Jersey.

The following non-limiting example will serve to illustrate the invention. It will be appreciated that variations in proportions and alternatives in elements of the components of the radiation sensitive coating composition will be apparent to those skilled in the art and are within the scope of the present invention.

### EXAMPLE 1

A carbon black dispersion was prepared by milling together: 4.7 parts by weight of a poly (vinyl propional) resin; 5.8 parts by weight of Carbon Black (Degussa Special 250); and 89.5 parts by weight of a 1:1 mixture of propylene glycol methyl ether and butyrolactone.

A coating solution was prepared by adding 2 parts by weight of the above dispersion to 8 parts by weight of AZ-5214 positive photoresist solution (available from AZ Photoresist Products, Somerville, NJ).

A mechanically roughened and anodically oxidized aluminum sheet, the surface of which has been rendered hydrophilic by treatment with an aqueous solution of polyvinyl phosphonic acid and dried was coated with this coating solution and dried to obtain a dry coating weight of 1.7 g/m².

The plate obtained was exposed by scanning it at a scan speed of 10 m/sec with a diode laser emitting at a wavelength of 832 nm, and having a spot size of 10 microns and an output power of 48 mw.

The exposed plate was developed by wiping with a pad saturated with P-800 positive plate developer available from the Agfa Division of Bayer Corporation. The exposed areas of the plate coating get washed away, leaving behind the unexposed coating. The finished sample shows both 10 micron positive and negative lines.

### EXAMPLE 2

A coated aluminum sample was prepared as in EXAMPLE 1, but using 3 parts by weight of the black dispersion and 7 parts by weight of the photoresist solution, at a dry coating weight of 2.0 g/m². Plate was exposed and processed as in EXAMPLE 4. At a scan speed of 12.2 m/sec, 66 mw of power was required to completely solubilize the exposed areas of the plate.

### EXAMPLE 3

EXAMPLE 2 was repeated at a dry coating weight of 1.5 g/m². The plate was exposed using a Nd:YAG laser using a wavelength of 1064 nm and 10 micron spot size and developed using PD-261 Positive Plate Developer, available from Agfa Division of Bayer Corporation. At a scan rate of 226 m/sec, a laser power of 3.35 W was required to completely solubilize the exposed areas of the plate. The exposed and developed plate rolled up quickly and printed several hundred clean impressions on a printing press.

### EXAMPLE 4

The following coating solution was coated on an aluminum substrate prepared as in EXAMPLE 1, at a dry coating weight of 1.2 g/m².

| Ingredient | Weight % |
|---|---|
| propylene glycol methyl ether | 18.7 |
| butyrolactone | 14.0 |
| 40% solution of cresol novolak resin in propylene glycol methyl ether acetate (Alnovol PN-400 from Hoechst AG) | 35.0 |
| ER1170/6 naphthoquinone diazide type positive sensitizer (Hoechst AG) | 2.3 |
| black dispersion from EXAMPLE 4 | 30.0 |

When exposed and developed as in EXAMPLE 1, 101 mw of laser power, at a scan rate of 10.1 m/sec was required to remove the exposed areas of the plate. When exposed and processed plates were put on press, 100,000 good copies were obtained without any deterioration of the printed images.

### EXAMPLE 5

An electrochemically roughened and anodically oxidized aluminum sheet, the surface of which has been rendered hydrophilic by treatment with an aqueous solution of polyvinyl phosphonic acid and dried was coated with the following coating composition and dried to obtain a dry coating weight of 1.2 g/m².

| Ingredient | Weight % |
|---|---|
| propylene glycol methyl ether | 26.49 |
| tetrahydrofuran | 53.00 |
| 40% solution of cresol novolak resin in propylene glycol methyl ether acetate (Alnovol PN-400 from Hoechst AG) | 10.5 |
| ER1170/6 naphthoquinone diazide type positive sensitizer (Hoechst AG) | 0.7 |
| 2,3,4 trihydroxybenzophenone | 0.3 |
| Edaplan (polysiloxane coating additive) | 0.01 |
| black dispersion from EXAMPLE 4 | 9.0 |

A full color image was electronically separated, at 2540 dots per inch, into its Yellow, Magenta, Cyan and black process color components, and the electronic separation files were used to directly image the above coated plates on a Gerber Crescent 42T platesetter (manufactured by Gerber Systems Inc., South Windsor, CT), at an exposure setting of 200. The plates were processed in an AGFA NP32 automatic plate processor, at a transport speed of 18''/min, using EP-262 Positive Plate Developer (available from AGFA OPS, Wiesbaden Germany) at 85 degrees F, and finished using Agfa RC-795 gum. Plates produced were used to print 8,000 high quality full color impressions.

### EXAMPLE 6

The plates of EXAMPLE 5 were imaged with process color separations of a full color image, separated at 2400 DPI, on a Creo Trendsetter thermal platesetter (manufactured by Creo Products of Burnaby, BC Canada) at an energy level of 200 mJ/cm², and processed in an AGFA PHW32 automatic plate processor, using an aqueous alkaline developer, at a transport speed of 25''/min. and a developer temperature of 85 deg. F. and finished with AGFA RC795 gum. 60,000 full color, commercial quality impressions were obtained on a 4 color web press using these plates. When these plates were baked in a Wisconsin Postbake oven at 525 degrees F. and a transport speed of 1m/min. A full commercial run of 1.3 million commercial quality full color impressions were obtain, with the plates showing no sign of image wear at the end of the run.

### EXAMPLE 7

The plates of EXAMPLE 5 were imaged with the 4 process color separations using a Gerber Crescent 42T platesetter, at an exposure setting of 138, and processed in an AGFA NPX60T automatic plate processor, using the developer and conditions of EXAMPLE 6, to yield plates showing 1-99% tint reproduction at 2540 DPI. These plates printed 230,000 full color commercial quality impressions before showing signs of wear.

### EXAMPLE 8

Example 1 is duplicated except the carbon black dispersion is prepared by milling together: 4.7 parts by weight of a resin from U.S. patent 4,631,245; 5.8 parts by weight of Carbon Black (Degussa Special 250); and 89.5 parts by weight of a 1:1 mixture of propylene glycol methyl ether and butyrolactone. Similar results are noticed.

## Claims

1. A positive working radiation sensitive composition suitable for laser induced imaging which comprises in admixture a water insoluble binder resin component which is either aqueous alkali soluble or swellable or becomes aqueous alkali soluble or swellable upon exposure, in an amount sufficient to form a uniform film of the composition components when it is coated on a substrate and dried; an o-quinone diazide radiation sensitive component in an amount sufficient to radiation sensitize the composition; and carbon black in an amount sufficient to absorb sufficient infrared radiation to cause the diazide to solubilize.

2. The composition of claim 1 wherein said water insoluble binder resin component is a novolak resin.

3. The composition of claim 1 or claim 2 wherein said water insoluble binder resin component is present in an amount of from 70 % to about 94 % based on the weight of the non-solvents parts of the radiation sensitive composition.

4. The composition of any of claims 1 to 3 wherein said radiation component is a 1,2-naphthoquinone diazide-4- or 5-sulfonic acid ester.

5. The composition of any of claims 1 to 4 wherein said radiation sensitive component is present in an amount of from about 1 % to about 20 % based on the weight of the non-solvents parts of the radiation sensitive composition.

6. The composition of any of claims 1 to 5 wherein said carbon black component is present in an amount of from about 5 % to abut 10 % based on the weight of the non-solvents parts of the radiation sensitive composition.

7. The composition of claim 1 wherein said binder resin component is present in the composition in an amount of from about 70 % to 94 %, and the radiation sensitive component is present in an amount of from about 1 % to about 20 %; and said carbon black component is present in an amount of from about 5 % to about 10 % based on the weight of the non-solvent parts of the radiation sensitive composition.

8. A positive working radiation sensitive element suitable for laser induced imaging which comprises a metal substrate and a positive working radiation sensitive composition coated and dried on the substrate, which positive working radiation sensitive composition is a composition as defined in any of claims 1 to 7.

9. The element of claim 8 wherein the substrate comprises aluminium.

10. A method for forming a positive image which comprises imagewise exposing a positive working radiation sensitive element according to claim 8 or 9 to laser induced infrared radiation, said exposing being conducted with laser light at a wavelength in the range of from about 800 to about 1100 nm at an energy level of from about 50 to about 250 mJ/cm²; and subsequently developing by removing the exposed nominage areas with an aqueous alkaline developer solution.

11. The method of claim 10 wherein said exposing is conducted with laser light at an energy level of from about 100 to about 150 mJ/cm².

12. The method of claim 10 wherein said exposing is conducted with a YAG laser at a wavelength of 1064 nm or with a diode laser at a wavelength of 830 nm.

13. The method of claim 10, 11 or 12 wherein the exposing is conducted by raster scanning a modulated beam of laser light across the dried radiation sensitive composition.

14. The method of any of claims 10 to 13 wherein the aqueous alkaline developer solution has a pH range of from about 10 to about 14.

15. The method of any of claims 10 to 14 wherein the aqueous alkaline developer solution comprises an aqueous solution of one or more components selected from the group consisting of mono-, di- and tri- alkali metal phosphate, alkali metal silicate, alkali metal metasilicate, alkali metabisulfite; and alkali metal hydroxide.

16. The method of any of claims 10 to 13 wherein the aqueous alkaline developer solution has a pH in the range of from about 12.5 to about 13.5 and comprises an aqueous solution of one or more components selected from the group consisting of sodium metasilicate, sodium hydroxide, potassium metasilicate and potassium hydroxide.
